Europäisches Patentamt

European Patent Office

Office européen des brevets

(11) Veröffentlichungsnummer: **0 334 980 B1**

(12) **EUROPÄISCHE PATENTSCHRIFT**

(45) Veröffentlichungstag der Patentschrift: **26.05.93**

(51) Int. Cl.5: **H03D 13/00**

(21) Anmeldenummer: **88105166.8**

(22) Anmeldetag: **30.03.88**

(54) **Filterschaltung.**

(43) Veröffentlichungstag der Anmeldung:
**04.10.89 Patentblatt 89/40**

(45) Bekanntmachung des Hinweises auf die
Patenterteilung:
**26.05.93 Patentblatt 93/21**

(84) Benannte Vertragsstaaten:
**DE FR NL**

(56) Entgegenhaltungen:
**WO−A−82/02987**
**DE−A− 2 627 701**
**US−A− 4 291 274**

**IEEE JOURNAL OF SOLID−STATE CIRCUITS,
Band SC−22, Nr. 2, April 1987, Seiten
255−261, IEEE, New York, US; D.−K. JEONG
et al.: "Design of PLL−based clock generation circuits"**

(73) Patentinhaber: **Deutsche ITT Industries GmbH
Hans−Bunte−Strasse 19 Postfach 840
W−7800 Freiburg i.Br.(DE)**

(72) Erfinder: **Giebel, Burkhard, Dipl.−Ing.
Berliner Strasse 25/2
W−7819 Denzlingen(DE)**

Rank Xerox (UK) Business Services
(3.10/3.6/3.3.1)

## Beschreibung

Die Erfindung betrifft eine Filterschaltung für eine digitale PLL – Schaltung, also eine Phase – Locked – Loop – Schaltung, mit einem digitalen Frequenz/Phasen – Diskriminator, der zwei Recht – ecksignale abgibt.

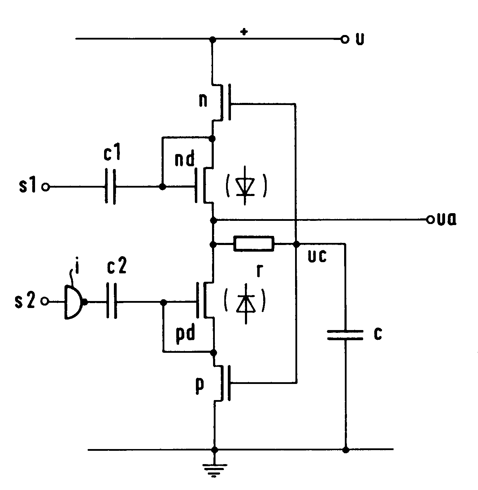

In der Zeitschrift "IEEE Journal of Solid – State Circuits", 1987, Seiten 255 bis 261 ist für die angegebene Verwendung anhand der Fig. 3b auf Seite 256 eine einfache CMOS – Filterschaltung erläutert, die aus der Serienschaltung der gesteu – erten Strompfade eines P – und eines N – Transi – stors besteht, die zwischen den beiden Polen einer Betriebsspannungsquelle liegt. Jeweils ein Recht – ecksignal ist einem der Gates als Steueranschluß der beiden Transistoren zugeführt, während deren gemeinsamer Verbindungspunkt mit einem Serien – RC – Glied zum einen Pol der Betriebs – spannungquelle hin beschaltet ist. An diesem Ver – bindungspunkt ist über einen Längswiderstand die geglättete Spannung abgenommen, die dem Steuereingang des spannungsgesteuerten Oszilla – tors (voltage controlled oscillator) der PLL – Schal – tung zugeführt ist. Die beiden Rechtecksignale werden vom Frequenz/Phasen – Diskriminator er – zeugt.

Die vorbeschriebene Filterschaltung weist unter anderem den Nachteil auf, daß die Rechtecksignale über parasitäre Kapazitäten zwischen dem Gate und Source/Drain der beiden Transistoren zum Ausgang übertragen werden. Auch ist die Aus – gangsspannung ua auf den Bereich zwischen dem Betrag der Steueranschluß – Schwellspannung $u_{tn}$ des N – transistors und der um den Betrag der Steueranschluß – Schwellspannung $u_{tp}$ des P – Transistors verminderten Betriebsspannung u be – grenzt: ua = u – $|u_{tp}|$ – $|u_{tn}|$.

Hier will nun die im Anspruch gekennzeichnete Erfindung Abhilfe schaffen, indem sowohl das Einkoppeln der beiden Rechteckspannungen auf die Ausgangsspannung weitgehend vermieden ist als auch der Ausgangsspannungsbereich vergrö – ßert ist.

Die Erfindung wird nun anhand der Figur der Zeichnung, die das Schaltbild eines Ausführungs – beispiels in CMOS – Technik darstellt, näher er – läutert.

In der Figur liegt zwischen dem Pluspol + und dem Minuspol der Betriebsspannungsquelle u, der mit Masse verbunden ist, die Serienschaltung der gesteuerten Strompfade des N – Transistors n, des als Diode geschalteten N – Transistors nd, des als Diode geschalteten P – Transistors pd und des P – Transistors p. Die Transistoren nd, pd sind dadurch als Diode geschaltet, daß ihr Steueranschluß, also ihr Gate, mit dem Verbindungspunkt des jeweiligen Transistors mit dem zugehörigen N – bzw. P –

Transistor verbunden ist; sie stellen somit wider – standsbehaftete Dioden dar.

Dem Steueranschluß des diodengeschalteten N – Transistors nd ist das erste Rechtecksignal s1 über den ersten Kondensator c1 zugeführt. Dem Steueranschluß des diodengeschalteten P – Tran – sistors pd ist das zweite Rechtecksignal s2 über den Inverter i und den zweiten Kondensator c2 zugeführt.

Der Verbindungspunkt der beiden diodenge – schalteten Transistoren nd, pd ist der Ausgang für die geglättete Ausgangsspannung ua, und an ihm ist das Serien – RC – Glied r, c angeschlossen, das zum Minuspol – u der Betriebsspannungsquelle führt. Am Verbindungspunkt des Widerstandes r mit dem Kondensator c des RC – Glieds ist der jeweilige Steueranschluß, in der Figur als das Gate, des N – bzw. P – Transistors n, p angeschlossen.

Die Spannung am Gate des Transistors nd beträgt uc – $u_{tn}$ bzw. die am Gate des Transistors pd uc – $|u_{tp}|$, wobei die diodengeschalteten Tran – sistoren einer Diode mit dem ON – Widerstand des Transistors als Serienwiderstand entsprechen und mit uc die Spannung am Kondensator c bezeichnet ist. Nimmt danach z.B. das erste Rechtecksignal s1 einen H – Pegel an, der über den Kondensator c1 zum Transistor tn übertragen wird, so entlädt sich dieser Kondensator über den Transistor nd zum Ausgang ua hin und weiter über den Widerstand r zum Kondensator c. In inverser Weise wirkt das zweite Rechtecksignal s2 über den Transistor pd auf das RC – Gied und somit auf den Ausgang ua ein, wie dies auch in der eingangs genannten Li – teraturstelle für die dort gezeigte einfache Schal – tung erläutert ist.

Bei der erfindungsgemäßen Schaltung ist der Aussteuerbereich größer als bei der vorbeschrie – benen Schaltung, da z.B. der Kondensator c1 durch den Transistor n bis auf die Spannung +u vorgeladen werden kann. Somit erreicht die Aus – gangsspannung ua theoretisch den maximalen Wert u + (u – $2u_{tn}$). In vergleichbarer Weise gilt für die theoretisch minimale Spannung der Wert – (u – 2 $|u_{tp}|$ ). Der eben genannte maximale und minimale Wert für die Ausgangsspannung ua stellt die jeweils theoretische Ober – und Untergrenze dar, die in praxi jedoch nicht erreicht werden. So ist z.B. beim Ausführungsbeispiel in CMOS – Technik der Substratsteuereffekt der verwendeten MOS – Transistoren, der ohmsche Spannungsabfall an den diodengeschalteten Transistoren nd, pd und das Öffnen der Source – Drain – Substratdiode der Transistoren pd, nd dafür verantwortlich, daß der maximal mögliche Variationsbereich der Aus – gangsspannung ua nicht erreicht wird, er trotzdem jedoch wesentlich größer als bei der vorbeschrie – benen Schaltung ist.

Es liegt im Rahmen der Erfindung, anstatt der beim Ausführungsbeispiel der Figur verwendeten CMOS – Transistoren komplementäre Bipolartransistoren zu verwenden. Auch können die diodengeschalteten Transistoren nd, pd durch die Serienschaltung eines Widerstandes und einer Diode ersetzt werden.

**Patentansprüche**

1.  Filterschaltung für eine digitale PLL – Schaltung ( = Phase – Locked – Loop – Schaltung) mit einem digitalen Frequenz/Phasen – Diskriminator, der ein erstes und ein zweites Rechtecksignal (s1, s2), abgibt bei welcher Filterschaltung
    - der gesteuerte Strompfad eines N – bzw. eines P – Transistors (n, p) einseitig am Plus – bzw. Minuspol einer Betriebsspannungsquelle (u) liegt,
    - das jeweils andere Strompfadende des N – bzw. des P – Transistors (n, p) über einen derart als Diode geschalteten N – bzw. P – Transistor (nd, pd), daß dessen jeweiliger Steueranschluß am jeweiligen Verbindungspunkt der beiden N – bzw. P – Transistoren (n, nd; p, pd) angeschlossen ist, am Ausgang der Filterschaltung liegt, der über ein Serien RC – Glied (r, c) mit dem Minuspol verbunden ist,
    - dem Steueranschluß des diodengeschalteten N – Transistors (nd) das erste Rechtecksignal (s1) über einen ersten Kondensator (c1) und dem Steueranschluß des diodengeschalteten P – Transistors (pd) das zweite Rechtecksignal (s2) über die Serienschaltung eines Inverters (i) und eines zweiten Kondensators (c2) zugeführt ist und
    - der Steueranschluß des N – und der des P – Transistors (n, p) am Verbindungspunkt von Widerstand (r) und Kondensator (c) des RC – Glieds liegt.

**Claims**

1.  Filter circuit for a digital phase – locked loop ( PLL ) circuit, comprising a digital frequency/phase discriminator for generating a first and a second square – wave signal ( s1, s2 ), and in which filter circuit
    - the one end of the control led current path of an n – or a p – conducting transistor ( n, p) is applied to the plus or the minus pole respectively, of a source of supply voltage ( u ),
    - the respective other end of the controlled current path of the n – or the p – conducting transistor ( n, p ) is connected to the output of the filter circuit via an n – conducting or p – conducting transistor which is in such a way connected as a diode ( nd, pd ) that its respective control terminal ( gate ) is applied to the respective point connecting said two n – or p – conducting transistors, with said output of said filter circuit being connected across a series RC circuit ( r, c ) to said minus pole,
    - to the control terminal ( gate ) of said diode – connected n – conducting transistor ( nd ) there is fed said first square – wave signal ( s1 ) via a first capacitor ( c1 ), and to the control terminal ( gate ) of said diode – connected p – conducting transistor ( pd ) there is fed said second square – wave signal ( s2 ) via the series arrangement of an inverter ( i ) and of a second capacitor ( c2 ), and
    - the control terminal ( gate ) of said n – conducting transistor and the one of said p – conducting transistor ( n, p ) are applied to the point connecting the resistor ( r ) and the capacitor ( c ) of said RC circuit.

**Revendications**

1.  Circuit de filtre pour un circuit PLL numérique ( = circuit Phase – Locked – Loop) comportant un discriminateur numérique de fréquence/phase, qui délivre des premier et second signaux rectangulaires (s1,s2), et dans lequel
    - la voie de courant commandée d'un transistor à canal N ou d'un transistor à canal P (n,p) est raccordée, d'un côté, au pôle positif ou au pôle négatif d'une source de tension de service (u),
    - l'autre extrémité respective de la voie de courant du transistor à canal N ou à canal P (n,p) est raccordée, par l'intermédiaire d'un transistor à canal N ou à canal P (nd, pd), branché en tant que diode, de telle sorte que sa borne respective de commande est raccordée au point de jonction respectif des deux transistors à canal N ou à canal P (n,nd; p,pd), à la sortie du circuit de filtre, qui est reliée au pôle négatif par l'intermédiaire d'un circuit série RC (r,c),
    - le premier signal rectangulaire (s1) est envoyé à la borne de commande du transistor à canal N (nd) branché en diode, par l'intermédiaire d'un premier condenseur (c1), et le second signal rectangulaire (s2) est envoyé à la borne de commande du transistor d'un canal P (pd), branché en diode, par l'intermédiaire du circuit série formé d'un inverseur (i) et d'un second condensateur (c2), et

- la borne de commande du transistor à canal N et celle du transistor à canal P (np), est' raccordée au point de jonction de la résistance (r) et du condensateur (c) du circuit RC.